# EUROPÄISCHE PATENTSCHRIFT

(11) **EP 1 387 982 B1**
(45) Veröffentlichungstag und Bekanntmachung des Hinweises auf die Patenterteilung: **18.07.2007**
(21) Anmeldenummer: 02732727.9
(22) Anmeldetag: 17.05.2002
(51) Int. Cl.: F21V 13/02, F21V 5/02, F21V 11/06, F21Y 101/02

(54) **OPTISCHES ELEMENT MIT TOTALREFLEXION**
TOTAL REFLECTION OPTIC ELEMENT
ELEMENT OPTIQUE A REFLEXION TOTALE

(30) Priorität: 18.05.2001 DE 10124370
(43) Veröffentlichungstag der Anmeldung: 11.02.2004
(73) Patentinhaber: Zumtobel Lighting GmbH, 6850 Dornbirn (AT)
(72) Erfinder: LADSTÄTTER, Gerald, A-6833 Klaus (AT); BOHLE, Markus, A-6850 Dornbirn (AT)
(74) Vertreter: Schmidt-Evers, Jürgen
(86) Internationale Anmeldenummer: PCT/EP2002/005491
(87) Internationale Veröffentlichungsnummer: WO 2002/095290

(56) Entgegenhaltungen:
- EP-A- 0 800 035
- DE-A- 19 622 670
- DE-A- 19 637 199
- US-A- 3 712 713
- US-A- 4 519 675
- US-A- 5 839 823
- US-A- 5 880 886
- US-A- 6 092 904
- US-B1- 6 169 594

## Beschreibung

Die vorliegende Erfindung betrifft ein optisches Element zum Reflektieren und/oder Umlenken von in dieses eintretenden und wieder aus diesem austretenden Lichtstrahlen, wobei die Umlenkung bzw. Reflexion durch Totalreflexion erfolgt.

Ein derartiges optisches Element ist beispielsweise in der DE 199 23 225 A1 beschrieben und in Figur 7 dargestellt. Dieses bekannte optische Element 100 besteht aus einem plattenförmigen Basisteil 101, das an seiner Oberseite mit einer Vielzahl von Mikroprismen 102 besetzt ist, die sich unter Bildung von Einkerbungen 103 von ihrer Wurzel ausgehend verjüngen. Die Form dieser Mikroprismen 102 ist derart, daß Lichtstrahlen, die von der Oberseite her in sie eintreten, an ihren Seitenwänden 104 totalreflektiert werden, was zur Folge hat, daß diese Lichtstrahlen die im wesentlichen glatte Lichtaustrittsseite 105 des optischen Elements 100 nur in einem bestimmten Winkelbereich verlassen. Aufgrund dieser Begrenzung des Lichtaustrittswinkels wird durch dieses optische Element 100 hindurchtretendes Licht von einem Beobachter als entblendet empfunden.

Eine Entblendung findet allerdings nur für solche Lichtstrahlen statt, die über die Oberseite in die Mikroprismen 102 eintreten. Licht hingegen, welches zunächst in die Einkerbungen 103 und irgendwann später in das optische Element 101 eintritt, wird nicht durch die Totalreflexion entblendet und ist daher unerwünscht. Aus diesem Grund ist bei dem dargestellten bekannten optischen Element ein zusätzliches Abdeckelement in Form eines Gitters 106 vorgesehen, welches auf die Oberseite des optischen Elements 100 aufgebracht wird und lichtdurchlässige Bereiche 107 sowie lichtabsorbierende oder reflektierende Bereiche 108 aufweist. Die Anordnung der lichtdurchlässigen und lichtabsorbierenden Bereiche 107 und 108 entspricht dabei der Anordnung der Mikroprismen 102 und Einkerbungen 103, so daß ein Lichteintritt in die Einkerbungen 103 verhindert wird. Auf diese Weise wird sichergestellt, daß lediglich entblendetes Licht das optische Element 100 an seiner Lichtaustrittsseite 105 verläßt.

Das Herstellen und Anordnen eines derartigen Gitters 106 ist dann möglich, wenn die Abstände zwischen den Mikroprismen 102 ausreichend groß sind, also beispielsweise im Millimeter- oder Zentimeter-Bereich liegen. Die Tendenz geht jedoch dahin, die Mikroprismen selbst und damit auch die Abstände zwischen ihnen zu verkleinern. Dadurch wird es allerdings immer schwieriger, ein paßgenaues Abdeckungsgitter herzustellen und anzuordnen, insbesondere deshalb, weil durch Erwärmung Toleranzen in derart starkem Maße wirksam werden können, daß die Funktion der Abdeckung verhindert wird.

Ein ähnliches Problem ergibt sich bei einem aus der US 6,092,904 bekannten Lichtleitelement. Dieses besteht aus einem flachen transparenten Lichtleitkörper, der an einer Flachseite eine prismenartige Struktur aufweist, welche Lichtstrahlen unter Totalreflexion aus dem Lichtleitelement auskoppeln soll. Um die Totalreflexion zu ermöglichen, ist der Lichtleitkörper an seiner die Prismenstruktur aufweisenden Seite von einem sog. Kompensationskörper überdeckt, der eine zur Struktur der Prismen komplementäre Form aufweist und mit Hilfe von Abstandshaltern leicht versetzt zu dem Lichtleitkörper angeordnet ist. Hierdurch wird zwischen dem Lichtleitkörper und dem Kompensationskörper ein dünner Spalt gebildet, der die Totalreflexion an den Seitenflächen der Prismen ermöglicht. Die Abstandshalter sind dabei entweder separate Elemente, die vor dem Zusammenfügen des Lichtleitkörpers und des Kompensationskörpers aufgebracht werden, oder werden bereits bei der Herstellung des Kompensationskörpers, der beispielsweise im Spritzgießverfahren hergestellt werden kann, an den diesen angeformt.

Auch bei diesem bekannten Lichtleitelement ist für einen Erhalt der Totalreflexion von wesentlicher Bedeutung, dass der Lichtleitkörper und der Kompensationskörper paßgenau aufeinander abgestimmt sind. Ist dies nicht der Fall, so kann die Entstehung des für die Totalreflexion erforderlichen Spalts nicht mehr gewährleistet werden und die optischen Eigenschaften des Lichtleitelements verschlechtern sich. Wiederum besteht allerdings das Problem, dass eine paßgenaue Anfertigung von Lichtleitkörper und Kompensationskörper immer schwieriger und aufwendiger wird, je kleiner die Prismenstrukturen gewählt werden.

Aus der DE 196 37 199 A1 ist ferner bekannt, den zwischen zwei totalreflektieren Flächen eines Lichtumlenkelements befindlichen Freiraum mit einem pulverförmigen Trennmaterial aufzufüllen. Dieses Trennmaterial verhindert zwar, dass die beiden reflektierenden Flächen während der Herstellung des Lichtumlenkelements unmittelbar in gegenseitige Berührung kommen, ist allerdings für die spätere Verwendung des Lichtumlenkelements problematisch. So muß der von dem Trennmaterial aufgefüllte Freiraum später noch abgedeckt werden, um zu verhindern, dass das Trennmaterial später wieder herausfällt. Ferner bildet das pulverförmige Trennmaterial auch keinen homogenen lichtundurchlässigen Körper, der einen Lichteintritt an den Einkerbungen des Lichtumlenkelements vollständig verhindern würde.

Es ist daher Aufgabe der vorliegenden Erfindung, eine einfachere und kostengünstigere Möglichkeit zu schaffen, den Lichteintritt in die Einkerbungen zu verhindern. Insbesondere soll sichergestellt werden, dass der für die Totalreflexion erforderliche Freiraum neben den Reflexionsflächen zuverlässig erhalten wird. Gleichzeitig soll ein gewisser Schutz für die empfindlichen Oberflächen der Mikroprismen geschaffen werden.

Die Aufgabe wird durch ein optisches Element, welches die Merkmale des Anspruches 1 aufweist, gelöst. Dieses zeichnet sich dadurch aus, daß es aus einem transparenten Grundkörper besteht, der unter Bildung von Reflexionsflächen derart strukturiert oder geformt ist, daß zumindest ein Teil der beim Austreten aus dem transparenten Grundkörper auf die Reflexionsflächen auftreffenden Lichtstrahlen totalreflektiert wird. Ferner ist mindestens ein hinter den Reflexionsflächen angeordneter Abdeckkörper vorgesehen, wobei die Reflexionsflächen und die diesen zugewandten Flächen der bzw. des Abdeckkörper(s) derart aneinander angepaßt sind, daß zwischen ihnen ein dünner Spalt verbleibt oder lediglich punktuelle Kontakte bestehen, wobei der bzw. die Abdeckkörper erfindungsgemäß im flüssigen Zustand auf den Grundkörper aufgebracht sind.

Die erfindungsgemäße Lösung besteht somit analog zur US 6,092,904 zunächst darin, die Einkerbungsöffnungen nicht mit einem Gitter zu bedecken, sondern stattdessen zumindest diejenigen Flächen, die zur Totalreflexion verwendet werden, zu überdecken und zwar derart, daß im wesentlichen ein dünner Spalt verbleibt. Aufgrund dieses Spalts zwischen den Reflexionsflächen und dem Abdeckkörper bleibt gewährleistet, daß auch weiterhin die gewünschte Totalreflexion auftritt. Darüber hinaus bietet die Abdeckung einen Schutz, der ein Verkratzen oder Verschmutzen der Reflexionsflächen verhindert.

Gemäß der vorliegenden Erfindung erfolgt allerdings das Überdecken der Reflexionsflächen auf wesentlich einfachere Weise dadurch, dass der oder die Abdeckkörper im flüssigen Zustand auf den Grundkörper aufgebracht werden. Dabei ist zu beachten, daß das Material des transparenten Grundkörpers mit dem Abdeckmaterial nicht reagieren sollte, da andernfalls großflächige Verbindungen zwischen dem transparenten Körper und dem Abdeckmaterial an den Reflexionsflächen auftreten könnten, mit der Folge, daß die Fähigkeit der Totalreflexion verlorengeht. Werden hingegen geeignete Materialien verwendet, so entsteht automatisch ein die Totalreflexion hervorrufender mikroskopischer Spalt. Beispielsweise kann für den Fall, daß der transparente Grundkörper aus Polymethylmethacrylat (PMMA) besteht, als Abdeckmaterial Polyoxymethylen (POM) oder Polypropylen (PP) verwendet werden.

Die Erfindung betrifft auch ein Verfahren nach Anspruch 16, dem die Vorteile ebenfalls zukommen.

Weiterbildungen der Erfindung sind Gegenstand der Unteransprüche.

So kann für den Fall, daß der Grundkörper durch ein plattenartiges Basisteil mit Mikroprismen gebildet wird, vorgesehen sein, nicht lediglich die Reflexionsflächen zu bedecken sondern allgemein die zwischen den Mikroprismen angeordneten Einkerbungen vollständig mit einem Abdeckkörper auszufüllen, um hierdurch den Lichteintritt zu verhindern. Dies ist insbesondere dann einfach durchzuführen, wenn zumindest das Abdeckmaterial aus Kunststoff besteht, da in diesem Fall das Einbringen im flüssigem Zustand auf einfache Weise, beispielsweise mittels Spritzgießen erfolgen kann.

Gemäß einer Weiterbildung oder einer weiteren Ausfährungsform der Erfindung kann die Oberseite der Mikroprismen mit einer weiteren transparenten Platte bedeckt sein, welche aus dem gleichen Material wie der Grundkörper besteht und einstückig mit diesem verbunden ist. Dies kann dadurch erreicht werden, daß nach dem Füllen der Einkerbungen mit dem Abdeckmaterial eine weitere Schicht des Materials des transparenten Grundkörpers aufgebracht wird, welches eine Verbindung mit den Mikroprismen, nicht jedoch mit den Abdeckkörpern eingeht. Ein derartig ausgestaltetes optisches Element ist insbesondere dann, wenn es die Form einer Platte bzw. Scheibe aufweist, vorzugsweise für einen seitlichen oder schmalseitigen Lichteintritt und einen quer dazu gerichteten, insbesondere um im wesentlichen 90° versetzten, Lichtaustritt geeignet, der bei einer Scheibe oder Platte breitseitig angeordnet ist.

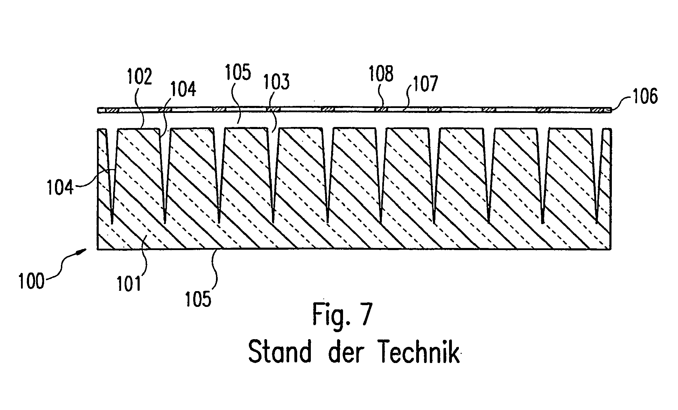

Das in Figur 7 dargestellte bekannte optische Element dient als sogenanntes Lichtleitelement, bei dem das Licht einer Lichtquelle über eine Lichteintrittsfläche in das Element eintritt und dieses über eine Lichtaustrittsfläche wieder verläßt. Darüber hinaus kann ein solches Element, bei einer geeigneten Ausgestaltung der Mikroprismen auch als Reflektor verwendet werden, wobei die Lichteintrittsfläche und die Lichtaustrittsfläche identisch sind und an den gegenüberliegenden Mikroprismen Totalreflexion stattfindet. Auch für diesen Fall ist das erfindungsgemäße Überdecken der Reflexionsflächen mit dem Abdeckmaterial von Vorteil, da die empfindlichen Reflexionsflächen vor äußeren Einflüssen geschützt sind. Hier besteht die Möglichkeit, die gesamte Seite des transparenten Grundkörpers, welche die Mikroplismen aufweist, mit dem Abdeckmaterial zu überdecken.

Darüber hinaus kann das Abdeckmaterial auch dazu verwendet werden, dem Reflektor die notwendige Stabilität zu verleihen, sofern der transparente Grundkörper selbst keine ausreichende Stabilität aufweist. Es besteht beispielsweise die Möglichkeit, den transparenten Grundkörper durch eine flexible Folie zu bilden, die auf einer Seite eine Mikroprismenstruktur aufweist. Wird die Folie in eine dem Reflektor entsprechende Form gebracht und anschließend mit dem Abdeckmaterial bedeckt, weist der Reflektor nach dem Erstarren des Abdeckmaterials eine ausreichende Stabilität auf. Hierdurch ist die Möglichkeit gegeben, auch komplexe Reflektorformen in einer einfachen und schnellen Weise herzustellen.

Schließlich kann das erfindungsgemäße optische Element auch derart ausgestaltet sein, daß innerhalb des transparenten Grundkörpers eine Lichtquelle, beispielsweise eine lichtemittierende Diode angeordnet ist. Durch den transparenten Grundkörper wird dann ein Reflektor gebildet, der ausschließlich mittels Totalreflexion das von der Lichtquelle emittierte Licht bündelt.

Im folgenden soll die Erfindung anhand der beiliegenden Zeichnung näher erläutert werden. Es zeigen:
- Fig. 1: ein erstes Ausführungsbeispiel eines erfindungsgemäßen optischen Elements;
- Fig. 2: eine Weiterbildung des in Fig. 1 dargestellten optischen Elements oder ein zweites Ausführungsbeispiel des optischen Elements;
- Fig. 2a: ein Stirnende des optischen Elements nach Fig. 2, das zu einer Leuchte ergänzt ist;
- Fig. 3: ein weiteres Ausführungsbeispiel eines erfindungsgemäßen optischen Elements, welches als Reflektor dient;
- Fig. 4a-d: die einzelnen Schritte eines Verfahrens zur Herstellung eines erfindungsgemäßen Reflektors;
- Fig. 5: ein weiteres Ausführungsbeispiel eines erfindungsgemäßen optischen Elements zum Bilden einer Leuchtdiodenanordnung;
- Fig. 6: ein weiteres Ausführungsbeispiel eines erfindungsgemäßen optischen Elements zum Bündeln des Lichts einer Leuchtdiode; und
- Fig. 7: ein bekanntes optisches Element.

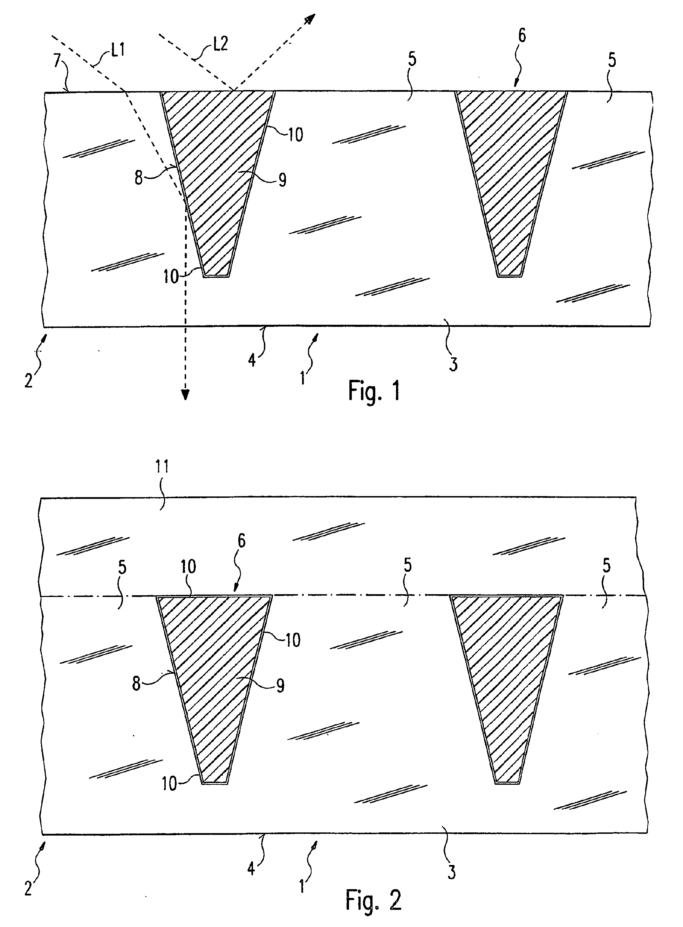

Das in Figur 1 dargestellte erste Ausführungsbeispiel des erfindungsgemäßen optischen Elements 1 entspricht dem aus Figur 7 bekannten optischen Element. Es besteht ebenfalls aus einem transparenten Grundkörper 2, der durch ein plattenartiges Basisteil 3 gebildet ist, dessen Unterseite 4 die Lichtaustrittsfläche des optischen Elements 1 bildet. An der der Lichtaustrittsseite 4 gegenüberliegenden Seite des Basisteils 3 befinden sich mehrere Mikroprismen 5, die sich von ihrer Wurzel ausgehend verjüngen, so daß zwischen den Mikroprismen 5 Einkerbungen 6 entstehen.

Die Funktion der Mikroprismen 5 besteht darin, daß ein an ihrer Oberseite 7 in den transparenten Grundkörper 2 eintretender Lichtstrahl die Lichtaustrittsfläche 4 unter einem vorgegebenen Winkelbereich verläßt. Die Lichtlenkung erfolgt dabei durch Totalreflexion an den Seitenflächen 8 der Mikroprismen, wie dies das Beispiel des Lichtstrahles L1 darstellt. Hierzu besteht der transparente Grundkörper 2 aus einem Material mit einem Brechungsindex, der größer als der Brechungsindex von Luft ist. Die zwei Brechungsindices bestimmen einen Totakeflexionswinkel, wobei Lichtstrahlen, die den Grundkörper 2 unter einem Winkel verlassen möchten, der größer als der Totakeflexionswinkel ist, reflektiert werden.

Die Totalreflexion in der für die Funktion des optischen Elements 1 gewünschten Art findet allerdings nur für Lichtstrahlen statt, welche über die Oberseiten 7 der Mikroprismen 5 in den Grundkörper 2 eintreten. Aus diesem Grund muß verhindert werden, daß Lichtstrahlen auch über die zwischen den Mikroprismen 5 gelegenen Einkerbungen 6 in den Grundkörper 2 eintreten können. Im Gegensatz zu dem in Figur 7 dargestellten bekannten optischen Element ist kein Abdeckungsnetz vorgesehen, stattdessen werden bei dem in Figur 1 dargestellten erfindungsgemäßen Ausführungsbeispiel die Einkerbungen 6 von Abdeckkörpern 9 vollkommen ausgefüllt. Das Material der Abdeckkörper 9 ist im dargestellten Beispiel reflektierend ausgebildet, so daß auf diese auftreffende Lichtstrahlen reflektiert werden, wie dies beispielsweise bei dem Lichtstrahl L2 der Fall ist.

Die Abdeckkörper 9 bieten darüber hinaus einen Schutz für die Reflexionsflächen 8 der Mikroprismen 5, so daß nicht die Gefahr besteht, daß diese verschmutzen oder verkratzen können. Erfindungsgemäß bestehen die Abdeckkörper 9 allerdings aus einem Material, daß sich nicht mit dem Material des Grundkörpers 2 verbindet bzw. lediglich punktuelle Kontakte bildet. Vorzugsweise bestehen der Grundkörper 2 einerseits und die Abdeckkörper 9 andererseits aus unterschiedlichen Materialien oder aus Materialien mit unterschiedlichen Lichtbrechungs-Indices. Dadurch entsteht ein mikroskopischer Spalt 10 zwischen den Seitenwänden des Grundkörpers 2 und den Abdeckkörpern 9, der gewährleistet, daß der zwischen dem Grundkörper 2 und Luft bestehende Totalreflexionswinkel unverändert bleibt. Dies bedeutet also, daß durch das Ausfüllen der Einkerbungen 6 mit den Abdeckkörpern 9 der gewünschte Effekt der Totalreflexion nicht beeinträchtigt wird.

Der Grundkörper 2 besteht vorzugsweise aus Kunststoff, beispielsweise aus Polymethylmethacrylat (PMMA) und läßt sich somit auf einfache Weise beispielsweise mittels Spritzgießen herstellen. Auch für das Abdeckungsmaterial wird vorzugsweise ein Kunststoff, beispielsweise Polyoxymethylen (POM) oder Polypropylen (PP) verwendet. Diese beiden Materialien gehen - wie gewünscht - keine Verbindung mit dem Polymethylmethacrylat (PMMA) des Grundkörpers 2 ein, so daß der erfindungsgemäße Spalt 10 entsteht. Darüber hinaus können diese Materialien verflüssigt und damit ebenfalls mittels Spritzgießen in die Einkerbungen 6 eingebracht werden.

Ein Verfahren zum Herstellen des in Fig. 1 dargestellten optischen Elements kann dann beispielsweise darin bestehen, zuerst den transparenten Grundkörper 2 mittels Spritzgießen herzustellen und anschließend - sobald der Grundkörper 2 genügend ausgehärtet ist - die Einkerbungen 6 mit dem Abdeckmaterial zu füllen. Das Füllen der Einkerbungen 6 bzw. das Herstellen der Abdeckkörper 9 kann durch flüssiges Aufbringen des Materials der Abdeckkörper 9, insbesondere Kunststoff, erfolgen, z. B. durch Aufgießen, Spritzgießen oder Spritzprägen. Ein Zweikomponenten-Spritzgießen oder -Spritzprägen ist ebenfalls vorteilhaft. Beim Spritzprägen wird nach dem Einspritzen des Materials in an sich bekannter Weise der Druck im Formraum einer zugehörigen Form erhöht, z. B. durch eine geringfügige Verringerung des Formraums, wodurch das Material mit überall gleichmäßigem Druck zusätzlich in die Einkerbungen 6 gedrückt wird. Diese Verfahren zum Herstellen des optischen Elements 1 ist wesentlich einfacher durchzuführen, als das Abdecken der Einkerbungen 6 mit einem Abdeckungsgitter.

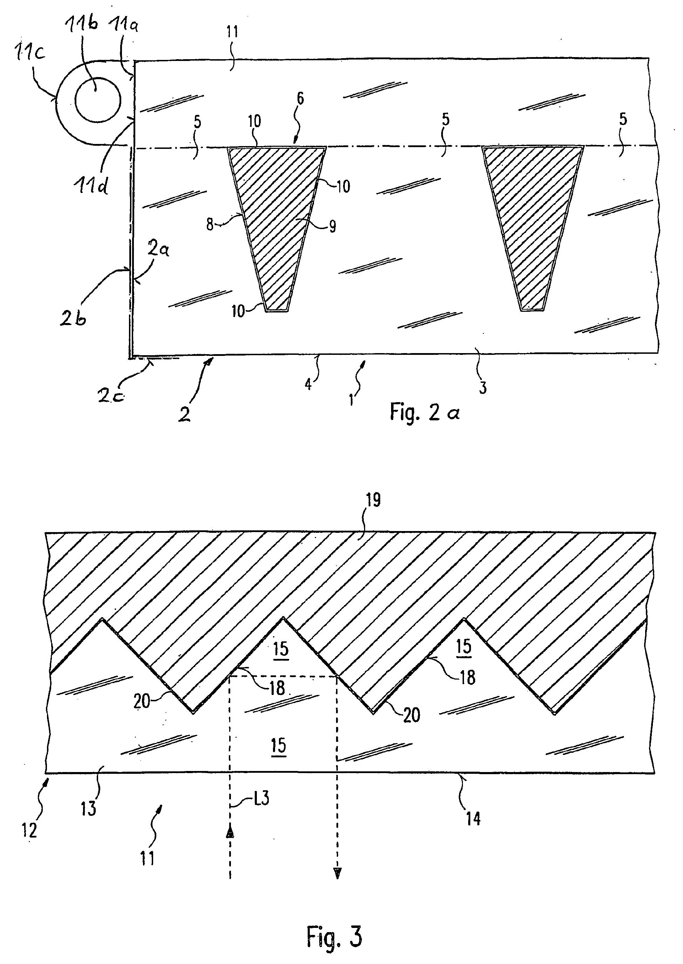

Figur 2 stellt eine Weiterbildung des in Figur 1 dargestellten Ausführungsbeispieles oder ein weiteres Ausführungsbeispiel dar und befaßt sich mit einem Problem, das ebenfalls bei dem in der DE 199 23 225 A1 beschriebenen optischen Element auftritt. So ist bei dem bekannten optischen Element eine zusätzliche transparente Abdeckung der Oberseiten der Mikroprismen vorgesehen, welche mit Hilfe eines transparenten Klebemittels aufgebracht wird. Das Schwierigkeit hierbei besteht darin, eine homogene Verbindung zwischen den Oberseiten der Mikroprismen und der Abdeckung zu erzielen. Durch die Verwendung des Klebemittels kann es zu Inhomogenitäten und Spalten kommen, durch die die optischen Eigenschaften des gesamten Elements verschlechtert werden.

Bei dem in Figur 2 dargestellten Ausführungsbeispiel sind die Oberseiten der Mikroprismen 5 ebenfalls mit einer transparenten Abdeckung 11, insbesondere in Form einer Platte, versehen, wobei diese Abdeckung 11 allerdings aus dem gleichen Material wie der Grundkörper 2 besteht und mit diesem einstückig verbunden ist. Dies wird dadurch erreicht, daß - wie zuvor in Bezug auf Figur 1 bereits beschrieben - zunächst der aus dem Basisteil 3 und den Mikroprismen 5 bestehende Grundkörper 2 gebildet wird, beispielsweise mittels Spritzgießen. In einem zweiten Schritt werden dann die sich zwischen den Mikroprismen 5 befindenden Einkerbungen 6 mit dem Abdeckmaterial aufgefüllt um die Abdeckkörper 9 zu bilden. In einem abschließenden Schritt wird dann die Oberseite wiederum mit dem Material des Grundkörpers 2 bedeckt, wobei sich die auf diese Weise gebildete transparente Platte 11 mit den Mikroprismen 5 homogen verbindet, während hingegen keine Verbindung zwischen der transparenten Platte 11 und dem Abdeckmaterial auftritt. Die Abdeckkörper 9 sind somit vollständig von dem transparenten Material des Grundkörpers 2 und der Abdeckung 11 unter Bildung von mikroskopischen Spalten 10 umschlossen. Das Aufbringen der Platte 11 bzw. Abdeckung kann ebenfalls durch Gießen, Spritzgießen oder Spritzprägen erfolgen.

Damit bietet die vorliegende Erfindung die Möglichkeit, derartige optische Elemente auf einfache und schnelle Weise herzustellen. Gegenüber den bekannten Elementen können die optischen Eigenschaften ferner deutlich verbessert werden, da keine Schnittstellen auftreten, an denen es zu ungewünschten Lichtstreuungen kommen kann. Ohne die Verwendung eines Klebstoffes oder dgl. kann hier eine einstückige und homogene Verbindung zwischen dem Grundkörper 2 und der transparenten Platte 11 erzielt werden. Die in Figur 2 dargestellte strichpunktierte Linie soll lediglich verdeutlichen, daß das Material für die transparente Platte 11 erst zu einem späteren Zeitpunkt aufgetragen wird.

Ein derartiges optisches Element 1 ist insbesondere auch für Anwendungen geeignet, bei denen Licht seitlich oder schmalseitig in die transparente Abdeckung 11 eingeleitet wird und im wesentlichen durch Totalreflexion innerhalb des optischen Elements derart umgelenkt wird, daß es an der Unterseite, insbesondere der breitseitigen Unterseite, austritt.

Fig. 2a zeigt beispielhaft den linken Endbereich einer Leuchte, bei der das optische Element 1 eine sogenannte Lichtleitplatte ist. Der schmalseitigen Stirnfläche 11a der transparenten Abdeckung 11 ist eine Lichtquelle 11b vorgeordnet, die das Licht in die Stirnfläche 11a einstrahlt. Zur verbesserten Lichtausnutzung der Lichtquelle 11b kann auf der der Abdeckung 11 abgewandten Seite der Lichtquelle 11b ein Reflektor 11c angeordnet sein, der das Licht in die Stirnfläche 11a reflektiert. Die Stirnfläche 11a bildet somit einen Lichteingang 11d. Der Stirnflächenbereich 2a des Grundkörpers 2 kann gegebenenfalls lichtundurchlässig abgedeckt sein, so daß das Licht der Lichtquelle 11b nur in den Lichteingang 11d eingestrahlt wird. Als Abdeckung 2b kann z. B. eine lichtundruchlässige Schicht oder ein Rahmen dienen, der als Halter für das optische Element 1 ausgebildet sein kann. Der Rahmen kann z. B. innen und vorzugsweise unterseitig einen Tragschenkel 2c aufweisen, auf dem das optische Element 1 aufliegen kann. Am Rahmen können gegebenenfalls auch die Lichtquelle 11b und/oder der Reflektor 11c gehalten sein. Der Rahmen kann auch der Befestigung der so gebildeten Leuchte dienen, z. B. als Anbauleuchte oder als abgehängte Leuchte. Die Lichtquelle 11b ist vorzugsweise eine sich längs der Stirnfläche 11a erstreckende Röhre, insbesondere eine Leuchtstoffröhre.

Der gegenüberliegende Endbereich der Leuchte kann entsprechend dem vorbeschriebenen Endbereich ausgebildet sein.

Die Schmalseiten der transparenten Abdeckung 11, die nicht der Lichteinstrahlung dienen, können lichtundurchlässig abgedeckt sein, z. B. durch eine entsprechende Beschichtung. Entsprechend können auch die Oberseite der transparenten Abdeckung 11 und die Schmalseiten des Grundkörpers 2 abgedeckt sein.

Das optische Element 1 ist nicht auf die vorbeschriebene und die in den Zeichnungen gemäß Fig. 1, 2 und 2a dargestellte Funktionsstellung beschränkt, bei der das Licht an der Unterseite abgestrahlt wird. Es ist im Rahmen der Erfindung auch möglich, das optische Element 1 hochkant anzuordnen, so daß es z. B. als Abstrahlelement für eine Wandleuchte oder als eine sonstige Lichtanzeige dienen kann.

Zu den beiden in den Figuren 1 und 2 dargestellten Ausführungsbeispielen ist zu bemerken, daß die Mikroprismen 5 grundsätzlich alle zum Erzielen der gewünschten Lichtlenkung geeigneten Formen annehmen können. Die erfindungsgemäße Überdeckung der Reflexionsseiten mit dem Abdeckmaterial hat auf die Form der Mikroprismen 5 keinerlei Einfluß, da die Totalreflexion an dem Übergang zwischen dem Material des transparenten Grundkörpers und der in dem Spalt befindlichen Luft stattfindet. Die optischen Eigenschaften des Abdeckmaterials sind hierfür unerheblich. Dementsprechend besteht die Möglichkeit, als Abdeckmaterial ein Material zu verwenden, welches reflektierend, absorbierend oder sogar farbig ist. Auch kann das optische Element als Lichtleitelement verwendet werden, wobei das Licht seitlich in das Lichtleitelement eingekoppelt und senkrecht dazu ausgekoppelt wird.

Figur 3 zeigt ein weiteres Ausführungsbeispiel des erfindungsgemäßen optischen Elements, das nun allerdings als Reflektor verwendet wird. Wiederum besteht das optische Element 21 aus einem transparenten Grundkörper 12 in Form eines plattenartigen Basisteils 13 mit darauf angeordneten Mikroprismen 15. Die Unterseite 14 des Basisteils 13 bildet nunmehr jedoch die Lichteintritts- und Lichtaustrittsfläche. Ein von der Unterseite her in den transparenten Grundkörper 12 eintretender Lichtstrahl L3 wird an ' den Seitenflächen 18 der sägezahnförmigen Mikroprismen 15 zweimal reflektiert, so daß er den Grundkörper 2 an seiner Unterseite 14 wieder verläßt.

Die Oberseite des transparenten Körpers 12 ist vollkommen mit einem Abdeckkörper 19 bedeckt, der wiederum keine bzw. lediglich eine punktuelle Verbindung mit dem Material des Grundkörpers 12 eingeht, so daß zwischen dem Abdeckkörper 19 und den Mikroprismen 15 ein mikroskopisch dünner Luftspalt 20 entsteht. Dies bedeutet, auch in diesem Ausführungsbeispiel erfolgt die Reflexion an den Seitenwänden 18 der Mikroprismen 15 durch Totalreflexion. Die Funktion des Abdeckkörpers 19 besteht in diesem Fall in erster Linie darin, die Oberflächen der Mikroprismen 15 vor äußeren Einflüssen zu schützen. Die Reflexion erfolgt allein durch die Form des transparenten Grundkörpers 12, der beispielsweise als sogenannter Retroreflektor, wie er beispielsweise bei einem Katzenauge zum Einsatz kommt, verwendbar ist.

Darüber hinaus kann durch die Wahl des Abdeckmaterials allerdings auch die Optik des Reflektors verändert werden. Beispielsweise kann das Abdeckmaterial reflektierend ausgestaltet sein, um die Reflexionseigenschaften nochmals zu erhöhen. Dies ist deshalb möglich, da Totalreflexion nur dann auftritt, wenn der Winkel zwischen dem Lichtstrahl und der total reflektierenden Oberfläche bestimmte Bedingungen erfüllt. Außerhalb dieser Winkelbereiche könnte das Licht den transparenten Körper 12 nach wie vor an seiner Oberseite verlassen. Umgekehrt besteht die Möglichkeit, das von der Oberseite her auf die Mikroprismen 15 auftretendes Licht auch an der Unterseite 14 des Grundkörpers 12 wieder austreten kann. Um dies zu verhindern, kann der Abdeckkörper 19 beispielsweise aus weißem Material bestehen und damit das Licht diffus zurückstrahlen. Auf der anderen Seite kann auch gezielt ein transparentes Material als Abdeckmaterial verwendet werden, falls ein Reflektor mit Durchlichteigenschaften erzielt werden soll.

Die Herstellung dieses Reflektors kann auf gleiche Weise wie die Herstellung des in Fig. 1 dargestellten optischen Elements erfolgen. Alternativ dazu besteht allerdings auch die Möglichkeit, zunächst den Abdeckkörper 19 zu formen - beispielsweise wiederum mittels Spritzgießen - und anschließend das transparente Material für den Grundkörper 12 aufzubringen. Schließlich wäre es auch denkbar, den Grundkörper und den Abdeckkörper zunächst getrennt voneinander herzustellen und erst anschließend zu der dargestellten Anordnung zusammenzusetzen.

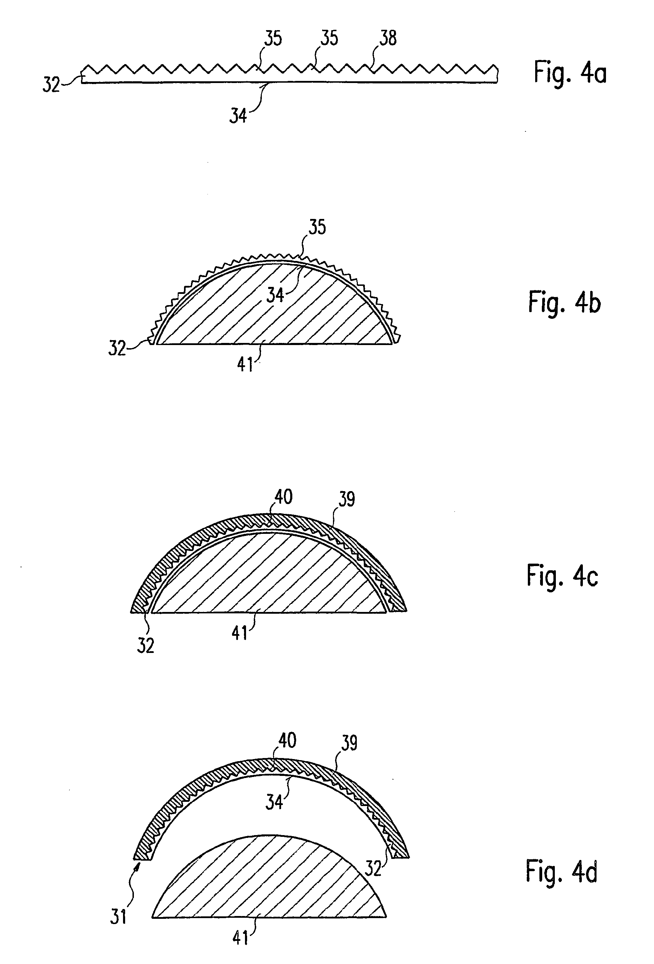

Der erfindungsgemäße Abdeckkörper kann darüber hinaus auch für die notwendige Stabilität des optischen Elements sorgen, wie dies anhand der Figuren 4a-d erläutert werden soll. Diese Figuren zeigen mehrere Schritte eines besonders einfachen Verfahrens zum Herstellen eines Reflektors.

Als Ausgangsmaterial für den Reflektor wird eine transparente flexible Folie 32 verwendet, welche später den transparenten Grundkörper bildet. Diese Folie weist eine flache Lichteintritts- und Lichtaustrittsseite 34 auf, sowie eine davon gegenüberliegende mit Mikroprismen 35 strukturierte Oberfläche. Die Mikroprismen 35 weisen die gleiche Form wie die in Figur 3 dargestellten Mikroprismen auf und sollen wiederum für eine Totalreflexion von Lichtstrahlen sorgen, die von der Unterseite 34 her in die Folie 32 eintreten.

Die Folie 32 selbst weist keine Eigenstabilität auf, und wird daher in einem ersten in Figur 4b dargestellten Schritt auf einen Formgebungskörper 41 aufgebracht, dessen Außenkontur der gewünschten Reflektorform entspricht. Die glatte Unterseite 34 der Folie 32 kommt dabei gegen die Oberseite des Formgebungskörpers 41 in Anlage.

In einem darauf folgenden Schritt (Figur 4c) wird dann die Oberseite der Folie 32 mit einem Abdeckmaterial 39 bedeckt, das erfindungsgemäß keine chemische Verbindung mit der Folie 32 eingeht, so daß an den Oberseiten der Mikroprismen 35 wiederum der mikroskopisch dünne Spalt 40 entsteht. Das erhärtbare Abdeckmaterial kann beispielsweise aufgespritzt oder aufgegossen werden.

In einem letzten Schritt (Figur 4d) wird dann nach dem Erhärten des Abdeckmaterials zu einem Abdeckkörper 39 die gesamte Anordnung von dem Formgebungskörper 41 entfernt, so daß ein Reflektor 31 gebildet wird, der wie der in Figur 3 beschriebene Reflektor aufgebaut ist. Der erstarrte Abdeckkörper 39 sorgt hierbei für eine ausreichende Stabilität.

Mit dem soeben beschriebenen Verfahren können auch komplizierte Reflektorformen auf einfache und schnelle Weise hergestellt werden. Insbesondere ist es wesentlich einfacher, eine flexible Folie herzustellen und dann in die gewünschte Form zu bringen, als bereits von Beginn an einen gekrümmten transparenten Basiskörper zu bilden, der auf seiner Oberfläche Mikroprismenstrukturen aufweist.

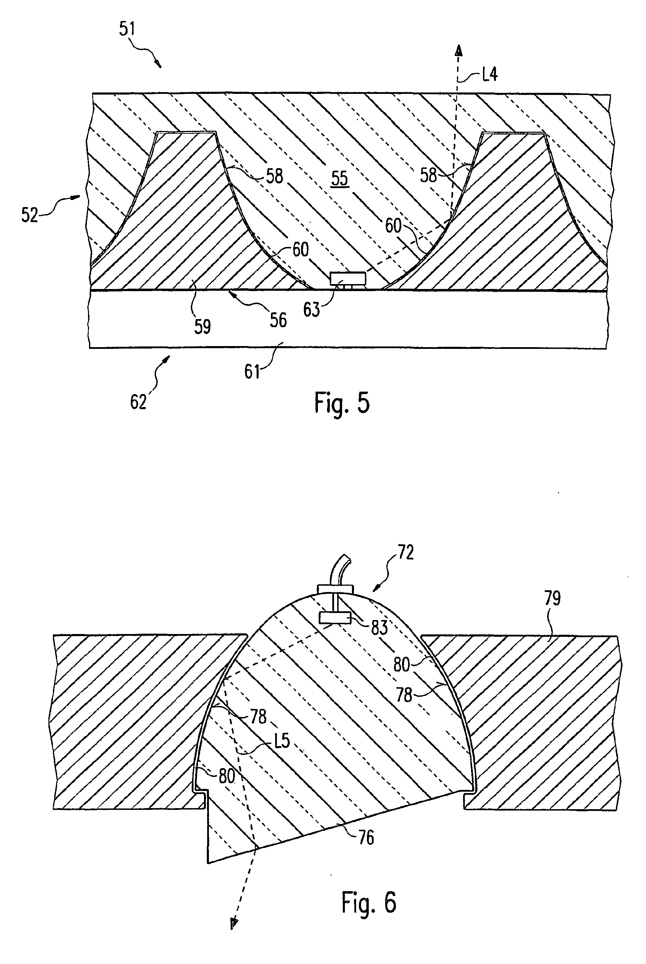

Ein weiteres Anwendungsgebiet für das erfindungsgemäße optische Element ist in Figur 5 dargestellt. Diese Figur 5 zeigt eine Leuchtdiodenanordnung 62, welche aus mehreren auf einer Platine 61 angeordneten LED-Chips 63 besteht. Werden eine Vielzahl solcher LED's 63 auf einer Platine 61 angeordnet, kann insgesamt eine ausreichend hohe Lichtstärke erzielt werden, so daß sich eine derartige Leuchtdiodenanordnung 62 auch zu Beleuchtungszwecken einsetzen läßt. Aus verfahrensökonomischen Gründen werden die Leuchtdioden 63 allerdings bevorzugt ungehäust angeordnet, d.h. lediglich der lichtemittierende Chip (das sogenannte Die) wird auf der Platine 61 befestigt. Dennoch ist es erwünscht, die von den Leuchtdioden 63 emittierten Lichtstrahlen zu bündeln, wobei das Anbringen einzelner Reflektoren hierfür allerdings äußerst aufwendig wäre.

Das in Figur 5 dargestellte Ausführungsbeispiel des erfindungsgemäßen optischen Elements 52 eignet sich dazu, die Strahlung der Leuchtdioden 63 zu bündeln. Hierfür sind die Leuchtdioden innerhalb eines glockenförmigen transparenten Körpers 55 angeordnet, dessen Form der Form eines geeigneten Reflektors entspricht. Um daher den gleichen Effekt wie bei einem Reflektor zu erzielen, ist es notwendig, den transparenten Grundkörper 55 wiederum derart zu gestalten, daß an seinen Seitenwänden 58 auftretende Lichtstrahlen reflektiert werden, wie dies beispielhaft durch den Lichtstrahl L4 dargestellt ist.

Wie auch in den Ausführungsbeispielen der Figuren 1-4 erfolgt daher die Reflexion durch Totalreflexion, was dadurch gewährleistet ist, daß der transparente Grundkörper 55 von Luft - genauer genommen wiederum von einem Luftspalt 66 - umgeben ist. Dies wird dadurch erreicht, daß die zwischen den glockenförmigen transparenten Grundkörpern 55 befindlichen Freiräume 56 mit dem Abdeckmaterial gefüllt sind, welches keine Verbindung mit dem Material der transparenten Körper 55 eingeht, so daß wiederum der mikroskopische Spalt 60 zur Gewährleistung der Totalreflexion entsteht.

Die Herstellung der Leuchtdiodenanordnung 62 geschieht vorzugsweise auf folgende Weise. Nach dem Anordnen der LED's 63 auf der Platine 61 werden zunächst die pyramidenartigen Erhebungen 59, die aus dem Abdeckmaterial bestehen, auf die Platine 61 aufgebracht, beispielsweise durch Kleben oder dgl. In einem darauffolgenden Schritt wird dann die gesamte Anordnung mit dem transparenten Material überzogen, so daß sich die dargestellte Anordnung ergibt. Auch dieses Verfahren zeichnet sich dadurch aus, daß eine an sich relativ komplizierte Struktur durch wenige und einfache Verfahrensschritte hergestellt werden kann. Insbesondere bietet das erfindungsgemäße Verfahren die Möglichkeit, Hinterschneidungen zu bilden.

Das in Figur 6 dargestellte letzte Ausführungsbeispiel befaßt sich ebenfalls mit dem Problem der Anordnung von Leuchtdioden zu Beleuchtungszwecken. Hierbei wird eine Leuchtdiode 83 zunächst in einen wiederum glockenförmigen transparenten Kunststoffkörper 72 eingegossen, der zugleich auch als Reflektor für die von der Leuchtdiode emittierten Lichtstrahlen L5 dienen soll. An seiner Unterseite weist der Kunststoffkörper 72 ferner einen schrägen Ansatz 76 auf, durch den das austretende Licht nochmals seitlich abgelenkt wird, so daß hierdurch die Strahlen gezielt in eine gewünschte Richtung gelenkt werden können.

Die Halterung des Kunststoffblocks 72 erfolgt durch eine Trägerschicht 79 aus dem Abdeckmaterial, in welche der transparente Kunststoffblock 72 eingegossen wurde. Wiederum bestehen der transparente Block 72 und die Halterung 79 aus Materialien, die keine innige Verbindung eingehen, so daß sich dementsprechend zwischen dem Kunststoffblock 72 und der Halterung 79 ein dünner Luftspalt 80 bildet. Dies hat zum einen zur Folge, daß die von der LED 83 emittierten und auf die Wand des Kunststoffblocks 72 auftreffenden Lichtstrahlen total reflektiert werden, darüber hinaus kann der Kunststoffblock 72 und damit der Ansatz 76 gegenüber der Halterung 79 nachträglich verdreht werden. Hierdurch besteht die Möglichkeit, nachträglich eine Änderung der Richtung, in die das Licht abgestrahlt werden soll, vorzunehmen.

Die vorliegende Erfindung zeichnet sich dadurch aus, daß optische Elemente mit hervorragenden optischen Eigenschaften erzielt werden können, die für eine Vielzahl von Anwendungsmöglichkeiten geeignet sind. Darüber hinaus können diese optischen Elemente auf einfache und kostengünstige Weise hergestellt werden. Selbst komplizierte Strukturen, die mit herkömmlichen Verfahren nur schwer zu erzielen sind, sind ohne großen Aufwand möglich.

## Patentansprüche

1. Optisches Element (1, 21, 31, 51, 71) zum Reflektieren und/oder Umlenken von in dieses eintretenden und wieder aus diesem austretenden Lichtstrahlen (L1, L3, L4, L5), mit
einem transparenten Grundkörper (2, 12, 32, 52, 72), der unter Bildung von den Grundkörper (2, 12, 32, 52, 72) begrenzenden Reflexionsflächen (8, 18, 38, 58, 78) derart strukturiert und/oder geformt ist, daß zumindest ein Teil der beim Austreten aus dem transparenten Grundkörper (2, 12, 32, 52, 72) auf die Reflexionsflächen (8, 18, 38, 58, 78) auftretenden Lichtstrahlen (L1, L3, L4, L5) total reflektiert wird,
sowie mit mindestens einem hinter den Reflexionsflächen (8, 18, 58, 78) angeordneten Abdeckkörper (9, 19, 39, 59, 79),
wobei die Reflexionsflächen (8, 18, 38, 58, 78) und die diesen zugewandten Flächen der/des Abdeckkörper(s) (9, 19, 39, 59, 79) aneinander angepaßt sind und zwischen ihnen ein dünner Spalt (10, 20, 40, 60, 80) verbleibt oder nur punktuelle Kontakte bestehen,
**dadurch gekennzeichnet,**
**daß** der bzw. die Abdeckkörper (9, 19, 39, 79) im flüssigen Zustand auf den Grundkörper (2,12,32,54,72) aufgebracht sind.

2. Optisches Element nach Anspruch 1,
**dadurch gekennzeichnet,**
**daß** der Grundkörper (2, 12) durch ein plattenartiges Basisteil (3, 13) gebildet wird, das an einer Seite mit Mikroprismen (5, 15) besetzt ist, die sich unter Bildung von Vertiefungen (6) - von ihrer Wurzel ausgehend - verjüngen, wobei die Seitenflächen der Mikroprismen (5, 15) die Reflexionsflächen (8, 18) bilden und die Abdeckkörper (9, 19) die Vertiefungen (6) zwischen den Mikroprismen (5, 15) ausfüllen.

3. Optisches Element nach Anspruch 2,
**dadurch gekennzeichnet,**
**daß** die Oberseiten der Mikroprismen (5) mit einer transparenten Platte (11) bedeckt sind, welche aus dem gleichen Material wie der Grundkörper (2) besteht und einstückig mit diesem verbunden ist.

4. Optisches Element nach Anspruch 2,
**dadurch gekennzeichnet,**
**daß** die die Mikroprismen (15) aufweisende Seite des Grundkörpers (12) vollständig von dem Abdeckkörper (19) überdeckt ist.

5. Optisches Element nach einem der Ansprüche 2 bis 4,
**dadurch gekennzeichnet,**
**daß** dieses plattenförmig ist.

6. Optisches Element nach einem der Ansprüche 2 bis 4,
**dadurch gekennzeichnet,**
**daß** dieses gekrümmt ist.

7. Optisches Element nach einem der vorherigen Ansprüche,
**dadurch gekennzeichnet**,
innerhalb des transparenten Grundkörpers (52, 72) eine oder mehrere lichtemittierende Dioden (63, 83) angeordnet sind.

8. Optisches Element nach einem der vorherigen Ansprüche,
**dadurch gekennzeichnet,**
**daß** der Abdeckkörper (9, 19, 39, 59, 79) reflektierend ist.

9. Optisches Element nach einem der vorherigen Ansprüche,
**dadurch gekennzeichnet,**
**daß** der bzw. die Abdeckkörper (9, 19, 39, 79) durch Gießen oder Spritzgießen oder Spritzprägen aufgebracht sind.

10. Optisches Element nach einem der vorherigen Ansprüche,
**dadurch gekennzeichnet,**
**daß** der transparente Grundkörper (2, 12, 32, 52, 72) und der Abdeckkörper (9, 19, 39, 59, 79) aus unterschiedlichen Materialien bestehen.

11. Optisches Element nach Anspruch 10,
**dadurch gekennzeichnet,**
**daß** der Grundkörper (2, 12, 32, 52, 72) und der auf diesen aufzugießende Abdeckkörper (9, 19, 39, 59, 79) aus Materialien bestehen, die keine Verbindung miteinander eingehen und **dadurch** zwischen sich einen Luftspalt (10) bilden.

12. Optisches Element nach einem der vorherigen Ansprüche,
**dadurch gekennzeichnet,**
**daß** der transparente Grundkörper (2, 12, 32, 52, 72) und/oder der Abdeckkörper (9, 19, 39, 79) aus Kunststoff besteht bzw. bestehen.

13. Optisches Element nach Anspruch 12,
**dadurch gekennzeichnet,**
**daß** der transparente Grundkörper (2, 12, 32, 52, 72) aus Polymethylmethacrylat (PMMA) besteht.

14. Optisches Element nach Anspruch 12 oder 13,
**dadurch gekennzeichnet,**
**daß** der Abdeckkörper (9, 19, 39, 59, 79).aus Polyoxymethylen (POM) besteht.

15. Optisches Element nach Anspruch 12 oder 13,
**dadurch gekennzeichnet,**
**daß** der Abdeckkörper (9, 19, 39, 59, 79) aus Polypropylen (PP) besteht.

16. Verfahren zum Bilden eines optischen Elements (1, 21, 31, 51, 71) zum Reflektieren und/oder Umlenken von in dieses eintretenden und wieder aus diesem austretenden Lichtstrahlen (L1, L3, L4, L5), mit den folgenden Schritten:
a) Herstellen eines transparenten Grundkörpers (2, 12, 32, 52, 72) mit einer derartigen Form, daß zumindest ein Teil der beim Austreten aus dem Grundkörper (2, 12, 32, 52, 72) auf Reflexionsflächen (8, 18, 38, 58, 78) auftreffenden Lichtstrahlen total reflektiert wird, und
b) Überdeckender Außenseiten der Reflexionsflächen (8, 18, 38, 58, 78) mit einem oder mehreren Abdeckkörpern (9, 19, 39, 59, 79), derart, daß die Reflexionsflächen (8, 18, 38, 58, 78) und die diesen zugewandten Flächen der/des Abdeckkörper(s) (9, 19, 39, 59, 79) aneinander angepaßt sind und daß zwischen ihnen ein dünner Spalt (10, 20, 40, 60, 80) verbleibt oder nur punktuelle Kontakte bestehen,
wobei der bzw. die Abdeckkörper (9, 19, 39, 59, 79) aus Kunststoff bestehen und im flüssigen Zustand auf den Grundkörper (2,12,32,52,72) aufgebracht und anschließend ausgehärtet werden.

17. Verfahren nach Anspruch 16,
**dadurch gekennzeichnet,**
**daß** die Abdeckkörper (9, 19, 39, 59, 79) mittels Spritzgießen oder Spritzprägen aufgebracht werden.

18. Verfahren nach Anspruch 16,
**dadurch gekennzeichnet,**
**daß** die Abdeckkörper (9, 19, 39, 59, 79) aufgegossen werden.

19. Verfahren nach einem der Ansprüche 16 bis 18,
**dadurch gekennzeichnet,**
**daß** transparenten Grundkörper eine flexible Folie (32) mit einer im wesentlichen glatten Lichteintrittsseite (34) und einer gegenüberliegenden, Mikroprismen aufweisenden Reflexionsseite ist,
wobei die Folie zunächst mit ihrer glatten Lichteintrittsseite auf einen Formgebungskörper angeordnet und anschließend auf die Reflexionsseite der Abdeckkörper aufgebracht wird.

20. Verfahren nach einem der Ansprüche 16 bis 19,
**dadurch gekennzeichnet,**
**daß** der transparenten Grundkörper (2, 12, 32, 52, 72) mittels Spritzgießen hergestellt wird.

21. Verfahren nach Anspruch 20,
**dadurch gekennzeichnet,**
**daß** beim Herstellen des transparenten Grundkörpers (52, 72) eine lichtemittierende Diode (63, 83) mit dem transparenten Material umschlossen wird.

22. Verfahren nach einem Anspruch 20 oder 21,
**dadurch gekennzeichnet,**
**daß** zunächst der Abdeckkörper (9, 19, 39, 59, 79) gebildet und anschließend der transparente Grundkörper (2, 12, 32, 52, 72) aufgebracht wird.

## Claims

1. Optical element (1, 21, 31, 51, 71) for reflecting and/or redirecting light rays (LI, L3, L4, L5) entering therein and again emerging therefrom, having
a transparent base body (2, 12, 32, 52, 72) which is so structured and/or formed that, with the formation of reflection surfaces (8, 18, 38, 58, 78) bounding the base body (2, 12, 32, 52, 72), at least a part of the light rays (L1, L3, L4, L5) impinging upon the reflection surfaces (8, 18, 58, 78) upon emergence from the transparent base body (2, 12, 32, 52, 72) are totally reflected,
and having at least one cover body (9, 19, 39, 59, 79) arranged behind the reflection surfaces (8, 18, 58, 78), the reflection surfaces (8, 18, 38, 58, 78), and the surfaces of the cover body or bodies (9, 19, 39, 59, 79) towards the reflection surfaces, being adapted to one another and between them there remaining a thin gap (10, 20, 40, 60, 80) or there existing only point contacts,
**characterized in that**,
the cover body or bodies (9, 19, 39, 79) are applied to the base body (2, 12, 32, 52, 72) in the liquid state.

2. Optical element according to claim 1,
**characterised in that**,
the base body (2, 12) is formed by means of a platelike base part (3, 13) which on one side is occupied by microprisms (5, 15) which taper - starting from their roots - with the formation of depressions (6), whereby the side surfaces of the microprisms (5, 15) form the reflection surfaces (8, 18) and the cover bodies (9, 19) fill the depressions (6) between the microprisms (5, 15).

3. Optical element according to claim 2,
**characterised in that**,
the upper sides of the microprisms (5) are covered with a transparent plate {11) which is of the same material as the base body (2) and is connected with the base body in one piece.

4. Optical element according to claim 2,
**characterised in that**,
the side of the base body (12) having the microprisms (15) is completely covered over by the cover body (19).

5. Optical element according to any of claims 2 to 4,
**characterised in that**,
it is plate-like.

6. Optical element according to any of claims 2 to 4,
**characterised in that**,
it is curved.

7. Optical element according to any preceding claim,
**characterised in that**,
one or more light emitting diodes (63, 83) are arranged within the transparent base body (52, 72).

8. Optical element according to any preceding claim,
**characterised in that**,
the cover body (9, 19, 39, 59, 79) is reflective.

9. Optical element according to any preceding claim,
**characterised in that**,
the cover body or bodies (9, 19, 39, 79) are applied by means of casting or injection moulding or injection compressing.

10. Optical element according to any preceding claim,
**characterised in that**,
the transparent base body (2, 12, 32, 52, 72) and the cover body (9, 19, 39, 59, 79) are of different materials.

11. Optical element according to claim 10,
**characterised in that**,
the base body (2, 12, 32, 52, 72) and the cover body (9, 19, 39, 59, 79) to be moulded thereon are of materials which enter into no connection with one another and thereby form an air gap (10) between them.

12. Optical element according to any preceding claim,
**characterised in that**,
the transparent base body (2, 12, 32, 52, 72) and/or the cover body (9, 19, 39, 59, 79) is or are of plastics.

13. Optical element according to claim 12,
**characterised in that**,
the transparent base body (2, 12, 32, 52, 72) is of polymethylmethacrylate (PMMA).

14. Optical element according to claim 12 or 13,
**characterised in that**,
the cover body (9, 19, 39, 59, 79) is of polyoxymethylene (POM).

15. Optical element according to claim 12 or 13,
**characterised in that**,
the cover body (9, 19, 39, 59, 79) is of polypropylene (PP).

16. Method for forming an optical element (1, 21, 31, 51, 71) for reflecting and/or redirecting light rays (LI, L3, L4, L5) entering therein and again emerging therefrom, having the following steps:
a) producing a transparent base body (2, 12, 32, 52, 72) having such a form that at least a part of the light rays incident on reflection surfaces (8, 18, 38, 58, 78) upon emergence from the base body (2, 12, 32, 52, 72) are totally reflected, and
b) covering over the outer sides of the reflection surfaces (8, 18, 38, 58, 78) with one or more cover bodies (9, 19, 39, 59, 79), such that the reflection surfaces (8, 18, 38, 58, 78) and surfaces of the cover body or bodies (9, 19, 39, 59, 79) towards these reflection surfaces are adapted to one another and that between them there remains a thin gap (10, 20, 40, 60, 80) or only point contacts exist,
the cover body or bodies (9, 19, 39, 59, 79) being of plastics and being applied to the base body (2, 12, 32, 52, 72) in the liquid state and subsequently hardened.

17. Method according to claim 16, **characterised in that**, the cover bodies (9, 19, 39, 59, 79) are applied by means of injection moulding or injection compressing.

18. Method according to claim 16, **characterised in that**, the cover bodies (9, 19, 39, 59, 79) are cast on.

19. Method according to any of claims 16 to 18,
**characterised in that**,
the transparent base body is a flexible foil (32) having a substantially smooth light entry side (34) and an opposite reflection side having microprisms, wherein the foil is initially arranged with its smooth light entry side on a shaping body and then applied to the reflection side of the cover body.

20. Method according to any of claims 16 to 19,
**characterised in that**,
the transparent base body (2, 12, 32, 52, 72) is produced by means of injection moulding.

21. Method according to claim 20,
**characterised in that**,
upon the production of the transparent base body (52, 72), there is enclosed with the transparent material a light emitting diode (63, 83) .

22. Method according to claim 20 or 21,
**characterised in that**,
the cover body (9, 19, 39, 59, 79) is initially formed and then the transparent base body (2, 12, 32, 52, 72) is applied.

## Revendications

1. Elément optique (1, 21, 31, 51, 71) pour réfléchir et/ou dévier les rayons lumineux entrant dans celui-ci et en ressortant (L1, L3, L4, L5), avec
un corps de base transparent (2, 12, 32, 52, 72) qui est structuré et/ou façonné en formant des surfaces de réflexion (8, 18, 38, 58, 78) délimitant le corps de base (2, 12, 32, 52, 72) de telle manière qu'au moins une partie des rayons lumineux (L1, L3, L4, L5) frappant les surfaces de réflexion (8, 18, 38, 58, 78) lors de leur sortie hors du corps de base transparent (2,12, 32, 52, 72) est totalement réfléchie,
et avec au moins un corps de recouvrement (9, 19, 39, 59, 79) disposé derrière les surfaces de réflexion (8, 18, 38, 58, 78),
dans lequel les surfaces de réflexion (8, 18, 38, 58, 78) et les surfaces des/du corps de recouvrement (9, 19, 39, 59, 79) dirigées vers celles-ci sont adaptées les unes aux autres et une fente mince (10, 20, 40, 60, 80) reste entre elles ou il se forme seulement des contacts ponctuels,
**caractérisé en ce que**
le ou les corps de recouvrement (9, 19, 39, 59, 79) est (sont) appliqué(s) à l'état liquide sur le corps de base (2, 12, 32, 52, 72).

2. Elément optique selon la revendication 1,
**caractérisé en ce que**
le corps de base (2, 12) est formé par une partie de base en forme de plaque (3, 13) qui est muni d'un côté de microprismes (5, 15) qui s'amincissent - en partant de leur racine - en formant des creux (6), les faces latérales des microprismes (5, 15) formant les surfaces de réflexion (8, 18) et les corps de recouvrement (9, 19) remplissant les creux (6) entre les microprismes (5, 15).

3. Elément optique selon la revendication 2,
**caractérisé en ce que**
les côtés supérieurs des microprismes (5) sont recouverts par une plaque transparente (11) qui est constituée du même matériau qu le corps de base (2) et qui est reliée à celui-ci d'un seul tenant.

4. Elément optique selon la revendication 2,
**caractérisé en ce que**
le côté du corps de base (12) comportant les microprismes (15) est complètement recouvert par le corps de recouvrement (19).

5. Elément optique selon l'une quelconque des revendications 2 à 4,
**caractérisé en ce que**
celui-ci est en forme de plaque.

6. Elément optique selon l'une quelconque des revendications 2 à 4,
**caractérisé en ce que**
celui-ci est recourbé.

7. Elément optique selon l'une quelconque des revendications précédentes,
**caractérisé en ce que**
une ou plusieurs diodes électroluminescentes (63, 83) sont disposées à l'intérieur du corps de base transparent (52, 72).

8. Elément optique selon l'une quelconque des revendications précédentes,
**caractérisé en ce que**
le corps de recouvrement (9, 19, 39, 59, 79) est réfléchissant.

9. Elément optique selon l'une quelconque des revendications précédentes,
**caractérisé en ce que**
le ou les corps de recouvrement (9, 19, 39, 59, 79) est (sont) appliqué(s) par moulage ou moulage par injection ou moulage par Injection-compression.

10. Elément optique selon l'une quelconque des revendications précédentes,
**caractérisé en ce que**
le corps de base transparent (2, 12, 32, 52, 72) et le corps de recouvrement (9, 19, 39, 59, 79) sont constitués de matériaux différents.

11. Elément optique selon la revendication 10,
**caractérisé en ce que**
le corps de base (2, 12, 32, 52, 72) et le corps de recouvrement (9, 19, 39, 59, 79) destiné à être couler sur celui-ci sont constitués de matériaux qui ne produisent aucune liaison l'un avec l'autre et qui forment, de ce fait, une fente (10) entre eux.

12. Elément optique selon l'une quelconque des revendications précédentes,
**caractérisé en ce que**
le corps de base transparent (2, 12, 32, 52, 72) et/ou le corps de recouvrement (9, 19, 39, 59, 79) est ou sont constltué(s) de matière plastique.

13. Elément optique selon la revendication 12,
**caractérisé en ce que**
le corps de base transparent (2, 12, 32, 52, 72) est constitué de polyméthacrylate de méthyle (PMMA).

14. Elément optique selon la revendication 12 ou 13,
**caractérisé en ce que**
le corps de recouvrement (9, 19, 39, 59, 79) est constitué de polyoxyméthylène (POM).

15. Elément optique selon la revendication 12 ou 13,
**caractérisé en ce que**
le corps de recouvrement (9, 19, 39, 59, 79) est constitué de polypropylène (PP).

16. Procédé pour la formation d'un élément optique (1, 21, 31, 51, 71) pour réfléchir et/ou dévier les rayons lumineux entrant dans celui-ci et en ressortant (L1, L3, L4, L5), avec les étapes suivantes :
a) fabrication d'un corps de base transparent (2, 12, 32, 52, 72) avec une forme telle qu'au moins une partie des rayons lumineux frappant les surfaces de réflexion (8, 18, 38, 58, 78) lors de leur sortie hors du corps de base (2, 12, 32, 52, 72) est totalement réfléchie, et
b) recouvrement des côtés extérieurs des surfaces de réflexion (8, 18, 38, 58, 78) avec un ou plusieurs corps de recouvrement (9, 19, 39, 59, 79) de telle manière que les surfaces de réflexion (8, 18, 38, 58, 78) et les surfaces des/du corps de recouvrement (9, 19, 39, 59, 79) dirigées vers celles-ci soient adaptées les unes aux autres et qu'une fente mince (10, 20, 40, 60, 80) reste entre elles ou qu'il se forme seulement des contacts ponctuels,
le ou les corps de recouvrement (9, 19, 39, 59, 79) étant constitué(s) de matière plastique et étant appliqué(s) à l'état liquide sur le corps de base (2, 12, 32, 52, 72) et étant ensuite durci(s).

17. Procédé selon la revendication 16,
**caractérisé en ce que**
les corps de recouvrement (9, 19, 39, 59, 79) sont appliqués par moulage par injection ou moulage par injection-compression.

18. Procédé selon la revendication 16,
**caractérisé en ce que**
les corps de recouvrement (9, 19, 39, 59, 79) sont coulés.

19. Procédé selon l'une quelconque des revendications 16 à 18,
**caractérisé en ce que**
le corps de base transparent est une feuille flexible (32) avec un côté d'entrée de lumière sensiblement lisse (34) et un côté opposé réfléchissant comportant des microprismes,
la feuille étant d'abord placée avec son côté d'entrée de lumière lisse sur un corps de façonnage, puis étant appliquée sur le côté réfléchissant du corps de recouvrement.

20. Procédé selon l'une quelconque des revendications 16 à 19,
**caractérisé en ce que**
le corps de base transparent (2, 12, 32, 52, 72) est fabriqué par moulage par injection.

21. Procédé selon la revendication 20,
**caractérisé** er ce que
lors de la fabrication du corps de base transparent (52, 72), une diode électroluminescente (63, 83) est entourée par le matériau transparent.

22. Procédé selon la revendication 20 ou 21,
**caractérisé en ce que**
le corps de recouvrement (9, 19, 39, 59, 79) est d'abord formé, puis le corps de base transparent (2, 12, 32, 52, 72) est appliqué.
